Europäisches Patentamt

European Patent Office

Office européen des brevets

(19)

(11) **EP 1 175 760 B1**

(12) **EUROPÄISCHE PATENTSCHRIFT**

(45) Veröffentlichungstag und Bekanntmachung des Hinweises auf die Patenterteilung:
**24.11.2004 Patentblatt 2004/48**

(51) Int Cl.7: **H04L 27/233**, H04L 7/02, H04L 7/10, H04L 7/04

(21) Anmeldenummer: **00938527.9**

(22) Anmeldetag: **02.05.2000**

(86) Internationale Anmeldenummer:
**PCT/DE2000/001372**

(87) Internationale Veröffentlichungsnummer:
**WO 2000/067441 (09.11.2000 Gazette 2000/45)**

(54) **VERFAHREN UND SCHALTUNGSANORDNUNG ZUR REGELUNG DES ABTASTTAKTS EINES PHASENMODULIERTEN SIGNALS**

METHOD AND CIRCUIT ARRANGEMENT FOR ADJUSTING THE SAMPLING RATE OF A PHASE-MODULATED SIGNAL

PROCEDE ET CIRCUIT POUR LA REGULATION DE TAUX D'ECHANTILLONNAGE D'UN SIGNAL MODULE EN PHASE

(84) Benannte Vertragsstaaten:
**DE FR GB**

(30) Priorität: **03.05.1999 DE 19920334**

(43) Veröffentlichungstag der Anmeldung:
**30.01.2002 Patentblatt 2002/05**

(73) Patentinhaber: **Infineon Technologies AG 81669 München (DE)**

(72) Erfinder: **SCHENK, Heinrich D-81476 München (DE)**

(74) Vertreter: **Banzer, Hans-Jörg, Dipl.-Ing. Kraus & Weisert Patent- und Rechtsanwälte Thomas-Wimmer-Ring 15 80539 München (DE)**

(56) Entgegenhaltungen:
**EP-A- 0 821 503**

• **GYSEL P ET AL: "TIMING RECOVERY IN HIGH BIT-RATE TRANSMISSION SYSTEMS OVER COPPER PAIRS" IEEE TRANSACTIONS ON COMMUNICATIONS,US,IEEE INC. NEW YORK, Bd. 46, Nr. 12, 1. Dezember 1998 (1998-12-01), Seiten 1583-1586, XP000790917 ISSN: 0090-6778**

• **SUGIYAMA A ET AL: "A FAST TIMING RECOVERY METHOD WITH A DECISION FEEDBACK EQUALIZER FOR BAUDRATE SAMPLING" IEICE TRANSACTIONS ON FUNDAMENTALS OF ELECTRONICS, COMMUNICATIONS AND COMPUTER SCIENCES,JP,INSTITUTE OF ELECTRONICS INFORMATION AND COMM. ENG. TOKYO, Bd. E79-A, Nr. 8, 1. August 1996 (1996-08-01), Seiten 1267-1273, XP000633542 ISSN: 0916-8508**

**Beschreibung**

Die vorliegende Erfindung betrifft ein Verfahren zur Regelung des Abtasttakts eines phasenmodulierten Signals, insbesondere eines QAM- oder CAP-Signals, nach dem Oberbegriff des Anspruches 1 sowie eine entsprechende Schaltungsanordnung nach dem Oberbegriff des Anspruches 11.

Ein derartiges Verfahren ist aus EP-A-0 821 503 bekannt.

Bei hohen Datenraten erweisen sich Frequenzmultiplexverfahren trotz höheren Bandbreitebedarfs für Duplex-Datenübertragungen über Telefonteilnehmer-Anschlußleitungen als günstiger als Basisbandgleichlageverfahren mit Echokompensation, da das in diesem Geschwindigkeitsbereich dominate Nebensprechen durch seletive Filterung unterdrückt werden kann. Für schnelle Datenübertragungen im Telefonteilnehmer-Anschlußbereich werden daher unter dem begriff VDSL (Very High Bit Rate Digital Subscriber Line) derzeit Einträgerverfahren, wie z.B. QAM (Quadraturamplitudenmodulation) und CAP (Carierless Amplitude/Phase Modulation) diskutiert, da hiermit verschiedene Fequenzbereiche für beide Übertragungsrichtungen in einfache Art und Weise durch eine geeignete Wahl der Träger- bzw. Mittenfrequenzen realisiert werden können.

QAM-Systeme werden bisher in vielen verschiedenen Anwendungen, u.a. in Sprachbandmodems, eingesetzt. Sendeseitig werden die zu übertragenden binären Daten jeweils in Gruppen von N Bits zusammengefaßt und einem Codierer zugeführt. Dieser ordnet jeder dieser $2^N$ Kombinationen einen bestimmten Punkt oder Signalvektor in einem zweidimensionalen Signalraum zu, der durch karthesische Koordinaten $a_I$, $a_Q$ definiert wird. Die einzelnen Signalpunkte können auch als Punkte in einer komplexen I/Q-Zahlenebene interpretiert werden.

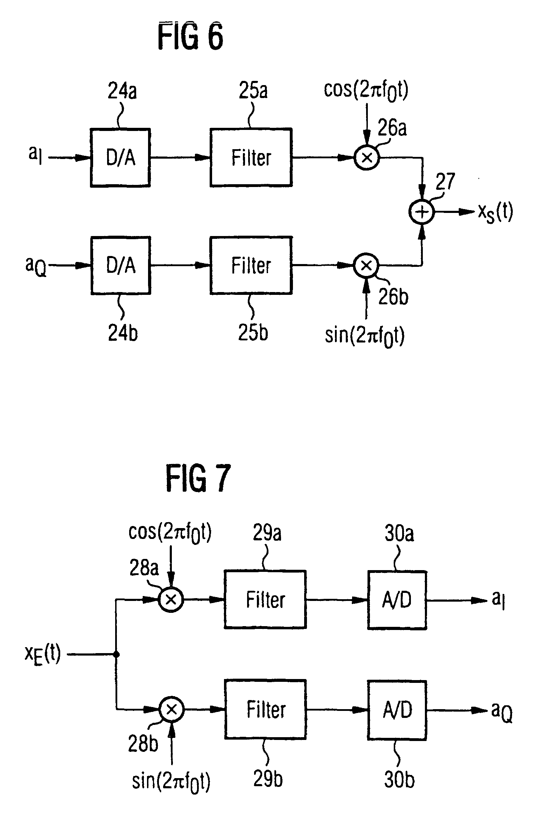

In Fig. 6 ist schematisch der Aufbau eines QAM-Modulators dargestellt, wie er meist in analogen Systemen eingesetzt wird. Die zu übertragenden Signalpunkte oder Signalvektoren, welche durch die Koordinaten $a_I$, $a_Q$ definiert sind, werden auf zwei separate Teilkanäle gegeben und mit Hilfe eines entsprechenden Digital/Analog-Wandlers 24a, 24b abgetastet und in entsprechende digitale Signalwerte umgesetzt. Nach einer Tiefpaßfilterung mit Hilfe von entsprechenden Tiefpaßfiltern 25a, 25b zur Unterdrückung störender Spektralanteile in der Umgebung der Abtastfrequenz werden die Teilsignale entweder durch einen Multiplizierer 26a mit dem Trägersignal $\cos(2\pi f_0 t)$ oder durch einen Multiplizierer 26b mit einem dazu orthogonalen Trägersignal $\sin(2\pi f_0 t)$ multipliziert und somit moduliert. Nach der Modulation werden die beiden Teilsignale in einem Addierer 27 addiert und als Sendesignal $x_s(t)$ an einen Empfänger übertragen.

Aufgrund der Multiplikation mit dem Trägersignal $\cos(2\pi f_0 t)$ bzw. dem dazu orthogonalen Signal $\sin(2\pi f_0 t)$ wird der Realteil $a_I$ des zu übertragenden komplexen Signalwerts/Signalvektors auch als Normal- oder In-Phase-Komponente und der Imaginärteil $a_Q$ als Quadraturkomponente bezeichnet.

Bei einer einfachen Phasenmodulation (PSK, Phase Shift Keying) liegen sämtliche zu übertragende komplexen Signalwerte in der komplexen Ebene auf einem Kreis, d.h. sie unterscheiden sich lediglich in der Drehung des entsprechenden Signalvektors und besitzen dieselbe Amplitude. Bei einer kombinierten Phasen- und Amplitudenmodulation, wie insbesondere der QAM, wird die gesamte komplexe Ebene ausgenutzt und jedem komplexen Signalwert eine Kombination aus einer bestimmten Trägeramplitude und einer entsprechenden Phase zugewiesen.

In Fig. 7 ist der Aufbau eines dem in Fig. 6 gezeigten QAM-Modulator entsprechenden QAM-Demodulators dargestellt. Ein quadraturamplitudenmoduliertes Empfangssignal $x_E(t)$ wird gleichzeitig Multiplizierern 28a, 28b zugeführt, welche das Empfangssignal mit dem Trägersignal $\cos(2\pi f_0 t)$ bzw. dem dazu orthogonalen Signal $\sin(2\pi f_0 t)$ multiplizieren und somit in das Basisband zurückmischen. Anschließend werden die beiden Basisbandsignale mit Hilfe von Tiefpaßfiltern 29a, 29b gefiltert, so daß störende Spektralanteile in der Umgebung der doppelten Trägerfrequenz, welche bei der Multiplikation mit den Trägersignalen entstehen, unterdrückt werden. Die somit erhaltenen geglätteten Basisbandsignale werden mit Hilfe von Analog/Digital-Wandlern 30a, 30b abgetastet, um die gewünschten Signalkomponenten $a_I$ und $a_Q$ zurückzugewinnen, und in einem (nicht gezeigten) Entzerrernetzwerk weiter verarbeitet.

Bei einer digitalen Realisierung des Demodulators muß das Empfangssignal $x_E(t)$ entsprechend zuerst abgetastet, d.h. digital/analog gewandelt, werden, um die Multiplikation mit den Trägersignalen und die Teifpaßfilterung rein digital durchzuführen.

Wie bereits beschrieben worden ist, werden bei der QAM die Modulation und Demodulation durch Drehung von Signalvektoren mit geeigneter Filterung durchgeführt. Eine Vereinfachung ergibt sich, wenn die Drehoperationen sowohl im Sender als auch im Empfänger unterdrückt werden, so daß keine Multiplikationen mit den Trägersignalen $\cos(2\pi f_0 t)$ und $\sin(2\pi f_0 t)$ durchgeführt werden müssen und der Frequenzbereich für das Sendesignal ausschließlich durch die verwendeten Filter festgelegt wird. Derartige Übertragungssysteme werden als CAP-Systeme (Carrierless Amplitude/Phase Modulation) bezeichnet. Ein CAP-Übertragungssystem ist nur dann mit einem entsprechenden QAM-Übertragungssystem äquivalent, wenn die Trägerfrequenz einem ganzzahligen Vielfachen der Abtastfrequenz entspricht. CAP-Übertragungssysteme besitzen gegenüber QAM-Übertragungssystemen insbesondere dann Vorteile, wenn eine digitale Realisierung gewünscht ist.

Bei Empfängern für phasenmodulierte Signale, insbesondere bei QAM- oder CAP-Empfängern, wird üblicherweise der Abtasttakt, mit dem das Signal abgetastet werden soll, mit Hilfe eines entscheidungsrückgekoppelten (Decision Feedback) Taktregelkriteriums geregelt. Dabei wird anhand des demodulierten und entzerrten Empfangssignalvektors die Signalkomponenten des entsprechenden Sendesignalvektors geschätzt und durch Vergleich des Empfangssignalvektors mit dem geschätzten Sendesignalvektor ein Phasenfehlersignal zur Regelung der Abtastphase in einem Abtasttakt-Regelkreis generiert. Diese Vorgehensweise besitzt im Vergleich zu nicht-entscheidungsrückgekoppelten Taktregelkriterien, bei denen die Regel- oder Einstellinformation für den Abtasttakt unmittelbar aus dem Empfangssignal durch nichtlineare Operationen (z.B. Betragsbildung) gewonnen werden, den Vorteil, daß ein günstigeres Jitterverhalten erzielt werden kann.

Nachteilig bei dieser Art der Abtasttaktregelung ist jedoch das Einlaufverhalten. Die Entzerrung des Empfangssignals erfolgt in der Regel mit Hilfe digitaler Filter, deren Filterkoeffizienten adaptiv eingestellt werden. Zu Beginn der Abtasttaktregelung ist jedoch bei noch nicht eingestellten Entzerrern die Wahrscheinlichkeit einer Fehlentscheidung relativ groß, so daß die Gefahr von Fehlsynchronisationen besteht.

Diese Gefahr einer Fehlsynchronisation kann dadurch reduziert werden, daß mit einem bezüglich 90° symmetrischen Signalkonstellation, beispielsweise einem 4-QAM/CAP-Signal, gearbeitet wird. Auch in diesem Fall können jedoch zufällige Fehlsynchronisationen auftreten. Bei Verwendung von Signalkonstellationen, die keine 90°-Symmetrie besitzen, ist bei einer reinen entscheidungsrückgekoppelten Abtasttaktregelung keine fehlerfreie Synchronisation gewährleistet. Derartige Signalkonstellationen werden jedoch derzeit für den oben erwähnten VDSL-Standard diskutiert.

Der vorliegenden Erfindung liegt daher die Aufgabe zugrunde, ein Verfahren und eine Schaltungsanordnung zur Regelung des Abtasttakts eines phasenmodulierten Signals, insbesondere eines amplituden/phasenmodulierten Signals, bereitzustellen, womit auch bei nichtsymmetrischen Signalkonstellationen eine fehlerfreie Taktsynchronisation erzielt werden kann.

Diese Aufgabe wird gemäß der vorliegenden Erfindung durch ein Verfahren mit den Merkmalen des Anspruches 1 bzw. eine Schaltungsanordnung mit den Merkmalen des Anspruches 11 gelöst. Die Unteransprüche definieren bevorzugte und vorteilhafte Ausführungsformen der vorliegenden Erfindung.

Die vorliegende Erfindung schlägt vor, während einer Startphase der Abtasttaktregelung zunächst einen möglichst optimalen Start-Abtasttakt bzw. eine möglichst optimale Start-Abtastphase zu ermitteln. Während dieser Startphase wird der üblicherweise für die Abtasttaktregelung vorgesehene Abtasttakt-Regelkreis deaktiviert und die Abtastung des Empfangssignals mit einem sich kontinuierlich ändernden Abtasttakt durchgeführt. Ebenso wird während dieser Startphase vorzugsweise die adaptive Einstellung der zuvor erwähnten digitalen Filter, welche zur Entzerrung vorgesehen sind, deaktiviert.

Während der Startphase wird bevorzugt eine reduzierte Signalkonstellation verwendet, wobei während der Startphase insbesondere lediglich vier unterschiedliche Signalwerte oder Signalvektoren verwendet werden können, die eine Untermenge der gemäß dem Übertragungssystem insgesamt möglichen Signalvektoren darstellen. Dabei sind diese Signalvektoren vorzugsweise derart zu wählen, daß sich dieselbe Sendeleistung wie beim Senden aller Signalvektoren ergibt.

Die Ermittlung der optimalen Abtastphase erfolgt insbesondere anhand eines Vergleichs des durch die Abtastung, Demodulation und Entzerrung gewonnenen Empfangssignalvektors und eines daraufhin geschätzten Sendesignalvektors, wodurch ein Fehlerwert berechnet wird, dessen Minimalwert zur Ermittlung des optimalen Abtastzeitpunkts überwacht wird.

Nach Ermittlung der optimalen Abtastphase wird der Abtasttakt-Regelkreis sowie die automatische und adaptive Einstellung der Filterkoeffizienten der digitalen Filter wieder aktiviert und die übliche Abtasttaktsynchronisation durch eine entscheidungsrückgekoppelte Taktregelung durchgeführt.

Die vorliegende Erfindung ermöglicht eine stabile Taktregelung und fehlerfreie Taktsynchronisation auch bei nichtsymmetrischen Signalkonstellationen, wobei die Erfindung allgemein auf analoge oder digitale Empfänger für phasenmodulierte Signale anwendbar ist. Vorzugsweise wird die Erfindung jedoch in digitalen QAM- oder CAP-Empfängern zur Abtasttaktsynchronisation eingesetzt.

Die Erfindung wird nachfolgend anhand eines bevorzugten Ausführungsbeispiels unter Bezugnahme auf die beigefügte Zeichnung erläutert.

Fig. 1 zeigt ein schematisches Blockschaltbild eines bevorzugten Ausführungsbeispiels einer erfindungsgemäßen Schaltungsanordnung zur Regelung des Abtasttakts eines QAM/CAP-Signals,

Fig. 2A-2D zeigen verschiedene vierstufige Signalkonstellationen, welche während einer Startphase bei der in Fig. 1 gezeigten Schaltungsanordnung zur Ermittlung einer optimalen Abtastphase verwendet werden können,

Fig. 3 zeigt einen möglichen Schaltungsaufbau eines in Fig. 1 gezeigten Fehlermittelwertbilders,

Fig. 4A und 4B zeigen Darstellungen zur Erläuterung der Ermittlung einer optimalen Abtastphase für den Fall der Verwendung einer nichtsymmetrischen Signalkonstellation während der Startphase,

Fig. 5A und 5B zeigen Darstellungen zur Erläuterung der Ermittlung einer optimalen Abtastphase für den Fall der Verwendung einer symmetrischen Signalkonstellation während der Startphase,

Fig. 6 zeigt einen vereinfachten Aufbau eines QAM-Modulators, und

Fig. 7 zeigt einen vereinfachten Aufbau eines QAM-Demodulators.

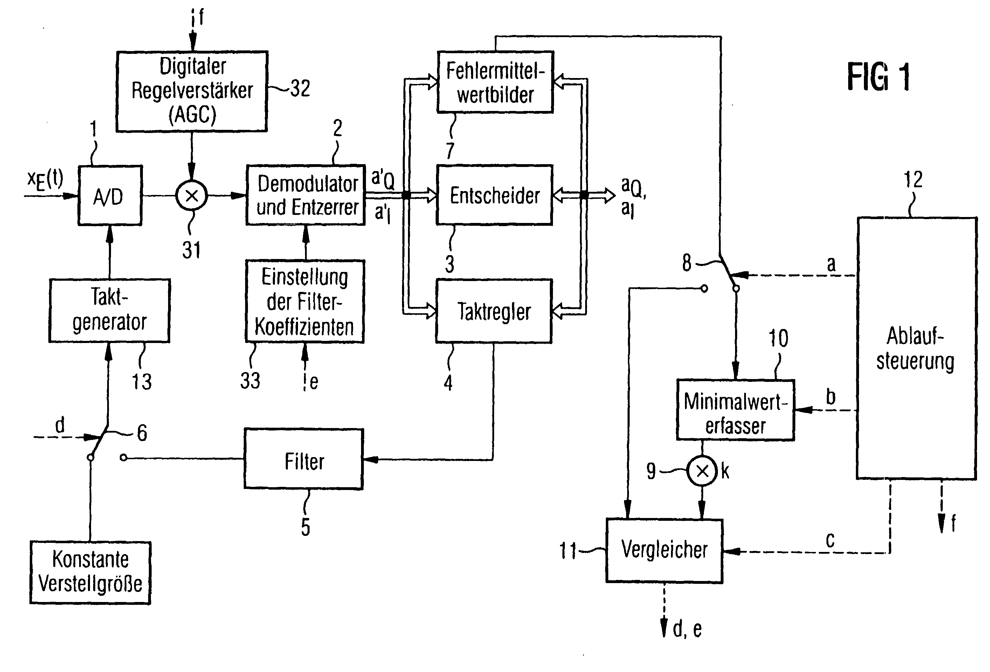

In Fig. 1 ist beispielhaft ein erfindungsgemäß aufgebauter QAM- oder CAP-Empfänger dargestellt. Ein in einem Sender entsprechend moduliertes und an den Empfänger übertragenes Empfangssignal $x_E(t)$ wird eingangsseitig mit Hilfe eines Analog/Digital-Wandlers 1 abgetastet und somit in einen binären Datenstrom umgesetzt, der anschließend gemäß dem gewählten Modulationsverfahren in einer entsprechenden Einrichtung 2 demoduliert und entzerrt wird. Die in Fig. 1 gezeigte Demodulator- und Entzerrereinrichtung 2 ersetzt die in Fig. 7 für den Fall eines analogen Demodulators dargestellte Struktur.

Üblicherweise wird die Entzerrung nach der Demodulation durchgeführt, wobei das demodulierte Signal mit der Abtastfrequenz oder der doppelten Abtastfrequenz einem vierkanaligen und komplexwertigen Entzerrer zugeführt wird, der in Form von digitalen Filtern realisiert ist. Dabei ist der Einsatz eines rein linearen Entzerrers oder einer Kombination aus linearen und entscheidungsrückgekoppelten Entzerrern möglich. Die Filterkoeffizienten des Entzerrers müssen im Betrieb adaptiv auf die aktuelle Übertragungsleitung bzw. den aktuellen Übertragungskanal eingestellt werden. Zu diesem Zweck ist ein entsprechender Regelkreis 33 vorgesehen, welcher adaptiv oder iterativ die optimale Einstellung der Filterkoeffizienten vornimmt.

Darüber hinaus ist wegen der starken Abhängigkeit der Dämpfung des Empfangssignals $x_E(t)$ von der jeweiligen Leitungslänge eine automatische Signalpegelregelung (Automatic Gain Control, AGC) erforderlich. Zu diesem Zweck ist zwischen dem Analog/Digital-Wandler 1 und dem Demodulator/Entzerrer 2 ein digitaler Regelverstärker 32 vorgesehen, der über einen Multiplizierer 31 den Empfangssignalpegel mit einem entsprechenden Faktor vergrößert/verringert. Das Regelsignal zur Einstellung des digitalen Regelverstärkers 32 wird von dem Ausgangssignal des Entzerrers abgeleitet. Um die Anforderungen an den Analog/Digital-Wandler 1 zu reduzieren, kann der Signalpegel des das Empfangssignals $x_E(t)$ bereits vor dem Analog/Digital-Wandler 1 analog verstärkt oder abgeschwächt und an die jeweilige Übertragungsleitung angepaßt werden.

Die von dem Demodulator und Entzerrer 2 gelieferten Komponenten $a'_I$ und $a'_Q$ eines komplexen Signalvektors bzw. komplexen Signalwerts des Empfangssignals $x_E(t)$ werden einer Entscheidungslogik 3 zugeführt. Dieser Entscheider 3 besitzt die Aufgabe, zu jedem empfangenen Wertepaar $a'_I$ und $a'_Q$ die entsprechenden tatsächlichen Sendedaten $a_I$ und $a_Q$ bzw. den entsprechenden Sendevektor abzuschätzen.

Die Regelinformation zur Einstellung der Filterkoeffizienten für den Regelkreis 33 wird unmittelbar aus der Differenz zwischen den an dem Entscheider 3 anliegenden Empfangsignalwerten $a'_I$ und $a'_Q$ und den von dem Entscheider 3 davon abhängig geschätzen Sendesignalwerten $a_I$ und $a_Q$ abgeleitet. Die adaptive Einstellung der Filterkoeffizienten erfolgt vorteilhafterweise durch Anwendung eines geeigneten Einstellalgorithmus, wie z.B. des sogenannten MSE-, SGN- oder SGN/SGN-Algorithmus.

Für eine fehlerfreie Funktion des in Fig. 1 gezeigten Empfängers ist weiterhin eine Regelung des Abtasttakts des Analog/Digital-Wandlers 1 erforderlich. Bei einer Veränderung der Abtastphase ist auch eine Veränderung der Filterkoeffizienten des Entzerrers 2 erforderlich, so daß die Regelung des Abtasttakts dafür sorgen muß, daß sich die Abtastphase im laufenden Betrieb nicht verändert. Zu diesem Zweck ist ein Abtasttakt-Regelkreis vorgesehen, der als wesentliche Elemente einen Taktregler 4 und einen davon abhängig angesteuerten Taktgenerator 13 umfaßt. Des weiteren befindet sich in dem Abtasttakt-Regelkreis ein Regelkreisfilter 5. Der Taktregler 4 erzeugt anhand eines entscheidungsrückgekoppelten Taktregelkriteriums durch Vergleich der empfangenen, entzerrten und demodulierten Signalvektorwerte $a'_I$ und $a'_Q$ mit dem durch den Entscheider 3 geschätzten Signalvektorwerten $a_I$ und $a_Q$ ein Einstellsignal für den Taktgenerator 13, um den Abtasttakt entsprechend einzustellen.

Da zu Beginn eines Verbindungsaufbaus zunächst mit Fehlentscheidungen bei der Abtasttaktregelung zu rechnen ist, kann kein sicherer Einlauf bzw. keine korrekte adaptive Einstellung des Entzerrers 2 und dessen digitalen Empfangsfilterpaares erwartet werden. Daher wird bei dem in Fig. 1 gezeigten Empfänger der eigenlichen Betriebsphase eine Startphase vorgeschoben, während der bei Deaktivierung des Abtasttakt-Regelkreises sowie der adaptiven Einstellung der Filterkkoeffizienten eine möglichst optimale Abtastphase für die Abtastung des Empfangssignals $x_E(t)$ ermittelt wird.

Während dieser Startphase wird in dem Übertragungssystem mit einer reduzierten Signalkonstellation gearbeitet, d.h. es werden lediglich komplexe Signalvektoren oder Signalwerte verwendet, welche eine Untermenge der insgesamt möglichen Signalwerte oder Signalvektoren darstellen. Insbesondere wird mit einer lediglich vierstufigen Signalkonstellation gearbeitet, so daß lediglich Signale mit vier verschiedenen Signalpunkten in der komplexen I/Q-Ebene übertragen werden. Dabei sind diese vier Signalpunkte möglichst so zu wählen, daß sich dieselbe Signalleistung wie beim Senden aller möglicher Signalpunkte ergibt, damit während dieser Startphase die sich im normalen Betrieb einstellenden Bedingungen möglichst gut simuliert werden können.

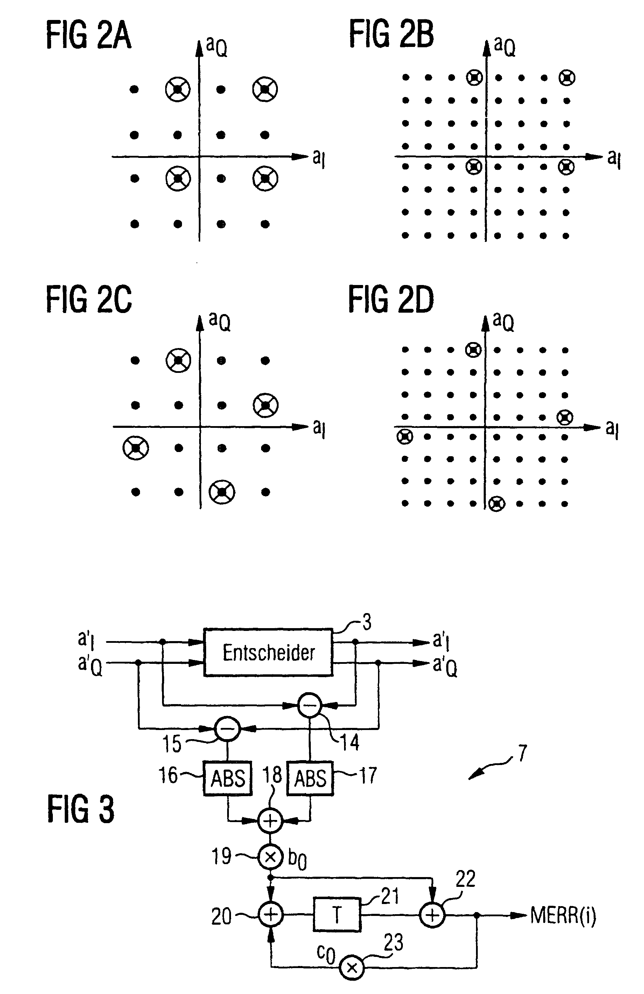

Fig. 2A bzw. 2B und 2C bzw. 2D zeigen während dieser Startphase mögliche Signalkonstellationen für ein im normalen Betrieb 16-stufiges bzw. 64-stufiges QAM/CAP-Übertragungssignal, wobei die möglichen vier Signalpunkte für die Start- oder Einlaufphase markiert sind. In Fig. 2A und 2B sind Beispiele für eine 4-stufige und nicht 90°-symmetrische Signalkonstellation für die Startphase dargestellt. In Fig. 2C und 2D sind hingegen entsprechende Beispiele für eine 4-stufige und 90°-symmetrische Signalkonstellation dargestellt.

Der Ablauf der Startphase wird zentral von einer in Fig.1 gezeigten Ablaufsteuerung 12 gesteuert. Diese Ablaufsteuerung 12 erzeugt direkt bzw. im Zusammenwirken mit einem nachfolgend noch näher beschriebenen Vergleicher 11 verschiedene Steuersignale a-f, welche auf entsprechende Komponenten der in Fig. 1 gezeigten Schaltungsanordnung einwirken. Die Ablaufsteuerung 12 sorgt während des Systemhochlaufs insbesondere dafür, daß sich die in Fig. 1 dargestellten einzelnen Regelungen nicht negativ beeinflussen können. Da der Signalpegel am Ausgang der digitalen Empfangsfilter des Entzerrers 2 sowohl von dem digitalen Regelverstärker 32 als auch von dem Regelkreis 33 zur Einstellung der Filterkoeffizienten beeinflußt wird, muß die Ablaufsteuerung dafür sorgen, daß immer nur eine dieser beiden Regelungen aktiv sein kann. Da zudem bei adaptiver Einstellung der Filterkoeffizienten durch den Regelkreis 33 und gleichzeitiger Regelung der Abtastphase durch den Abtasttakt-Regelkreis Verkoppelungen dieser beiden Regelungen auftreten können, welche zu einem instabilen Einlaufverhalten führen, muß die Ablaufsteuerung 12 des weiteren dafür sorgen, daß diese beiden Regelungen voneinander entkoppelt werden.

Die Ablaufsteuerung steuert daher den Ablauf der Startphase derart, daß zunächst mit Hilfe des Steuersignals f lediglich der digitale Regelverstärker 32 aktiviert wird. Während der Einstellphase des digitalen Regelverstärkers 32 ist sowohl der Abtasttakt-Regelkreis als auch der Regelkreis 33 zur adaptiven Einstellung der Filterkoeffizienten deaktiviert. Dies erreicht die Ablaufsteuerung über die Steuersignale d bzw. e, wobei das Steuersignal d direkt auf einen steuerbaren Schalter 6 einwirkt. Bei der in Fig. 1 gezeigten Stellung des Schalters 6 ist der Abtasttakt-Regelkreis geöffnet und somit deaktiviert. Während dieses ersten Abschnitts der Startphase verändert sich der Einstellwert des digitalen Regelverstärkers 32 solange bis der Signalpegel am Ausgang des Entzerrers 2 einen bestimmten Wert erreicht hat. Ab diesem Zeitpunkt wird der digitale Regelverstärker 32 durch die Ablaufsteuerung wieder deaktiviert.

Die adaptive Einstellung der Filterkoeffizienten des Entzerrers 2 darf jedoch erst dann wieder freigegeben werden, wenn die Abtastphase näherungsweise ihren von der zufälligen Anfangsphase abhängigen Endwert erreicht hat. Um diesen für die Aktivierung des Abtasttakt-Regelkreises und der adaptiven Einstellung der Filterkoeffizienten optimalen Wert der Abtastphase zu ermitteln, wird daher von der Ablaufsteuerung während der Startphase zunächst eine Trainingsphase für die Abtasttaktregelung gestartet, deren Ziel es ist, eine Abtastphase zu ermitteln, bei der eine Umschaltung auf die endgültige entscheidungsrückgekoppelte Abtasttaktregelung und die Freigabe der adaptiven Einstellung der Filterkoeffizienten ohne Auftreten von Fehlsynchronisationen möglich ist.

Während dieser Trainingsphase sorgt die Ablaufsteuerung daher dafür, daß der Abtasttakt-Regelkreis weiterhin unterbrochen und die adaptive Einstellung der Filterkoeffizienten durch den Regelkreis 33 deaktiviert ist. Der Entzerrer 2 wird in diesem Fall mit festen Startkoeffizienten betrieben. Der steuerbare Schalter 6 befindet sich in der in Fig. 1 gezeigten Stellung, so daß dem Taktgenerator 13 eine konstante Verstellinformation zugeführt und das Empfangssignal $x_E(t)$ mit einer sich konstant verändernden Abtastphase abgetastet wird. Diese konstante Verstellinformation ist insbesondere derart zu wählen, daß unter Berücksichtigung aller Frequenztoleranzen (Symbolrate des Empfangssignals $x_E(t)$ und interner Taktgenerator 13) ein minimaler Frequenzversatz zwischen der Sendesymbolrate und der aus dem Taktgenerator 13 abgeleiteten Empfangssymbolrate gewährleistet ist.

Am Eingang des Entscheider 3 tritt somit ein demoduliertes Empfangssignal mit einer entweder linear steigenden oder linear fallenden Abtastphase auf. Prinzipiell kann festgestellt werden, daß bei einer sich linear verändernden Abtastphase die optimale Abtastphase periodisch durchlaufen wird. Bei CAP-Systemen ergibt sich hierfür eine Periodendauer T, wobei T dem Kehrwert der Symbol- oder Baudrate entspricht. Bei bezüglich 90° symmetrischen Signalkonstellationen können im Abstand von Vielfachen von T/4 weitere suboptimale Abtastphasen auftreten. Bei QAM-Systemen kann sich bei Systemen ohne spezielle Trägerregelung abhängig von dem Verhältnis der Trägerfrequenz zu der Symbol- oder Baudrate eine wesentlich längere Periode für die optimale Abtastphase ergeben. In diesem Fall können bei Vielfachen von T suboptimale Abtastphasen auftreten.

Durch Vergleich dieses am Eingang des Entscheiders 3 auftretenden Empfangssignalvektors $a'_Q$, $a'_I$ mit dem von dem Entscheider 3 geschätzten Sendesignalvektor $a_Q$, $a_I$ kann die optimale Abtastphase ermittelt werden, d.h. als Kriterium für die Ermittlung der optimalen Abtastphase wird der Entscheidungsfehler ausgewertet. Dabei wird vorausgesetzt, daß sich im optimalen Abtastzeitpunkt mit dem durch seine Startkoeffizienten fest eingestellten Entzerrer 2 bei allen in Betracht kommenden Übertragungsleitungen eine deutlich reduzierte Fehlentscheidungsrate ergibt, was auch tatsächlich immer zutrifft. Durchläuft die Abtastphase ihren optimalen Wert, wird der jeweils berechnete mittlere quadratische oder mittlere absolute Fehler minimal.

Der mittlere absolute Entscheidungsfehler MERR(i) zum Abtastzeitpunkt i kann beispielsweise abhängig von den zu den Abtastzeitpunkten i und i-1 auftretenden Fehlern ERR(i) und ERR(i-1) mit Hilfe der folgenden rekursiven Beziehung ermittelt oder berechnet werden:

$$MERR(i) = c_0 \cdot MERR(i - 1) + b_0 \cdot (|ERR(i)|+|ERR(i-1)|)$$

mit

$$c_0 = (1 - 2^{-L})$$

$$b_0 = \frac{1}{2}(1-c_0)$$

Mit der Größe L wird die Zeitkonstante für die Mittelung vorgegeben, wobei die Mittelung beispielsweise mit Hilfe eines entsprechend der obigen rekursiven Beziehung aufgebauten digitalen Tiefpasses realisiert werden kann. Eine entsprechende Schaltung zur Berechnung des mittleren absoluten Fehlers MERR(i) ist beispielhaft in Fig. 3 dargestellt. Diese Schaltung umfaßt Subtrahierer 14, 15 zum Vergleichen der am Eingang des Entscheiders 3 anliegenden Empfangssignalvektor-Komponenten mit den vom Entscheider 3 geschätzen Sendesignalvektor-Komponenten, Absolutwertbilder 16, 17, einen Addierer 18 und einen Multiplizierer 19 mit dem Multiplikationsfaktor $b_0$ sowie eine digitale rekursive Filterstruktur, welche Addierer 20, 22 sowie ein Verzögerungsglied 21 und einen im Rückkopplungspfad angeordneten Multiplizierer 23 mit dem Multiplikationsfaktor $c_0$ umfaßt.

Die Trainingsphase für die Abtasttaktregelung teilt sich in zwei Abschnitte auf. Während des ersten Abschnitts wird zunächst der Minimalwert des gemäß obiger Beziehung berechneten Fehlermittelwerts ermittelt. Die Zeitdauer dieses Abschnitts muß so gewählt werden, daß die Abtastphase mindestens einmal den optimalen oder einen suboptimalen Wert durchläuft. Zur Ermittlung des Minimalwerts ist gemäß Fig. 1 ein entsprechender Minimalwerterfasser 10 vorgesehen, der den von einem Fehlermittelwertbilder 7, der beispielsweise gemäß Fig. 3 aufgebaut sein kann, gelieferten Fehlermittelwert kontinuierlich überwacht und bei Erreichen eines Minimalwerts diesen minimalen Fehlermittelwert speichert. Während dieses Abschnitts ist ein weiterer steuerbarer Schalter 8 von der Ablaufsteuerung 12 über ein Steuersignal a in die in Fig. 1 gezeigte Stellung geschaltet.

Anschließend wird der steuerbare Schalter 8 für den zweiten Abschnitt der Trainingsphase von der Ablaufsteuerung 12 umgeschaltet, so daß dem bereits erwähnten Vergleicher 11 einerseits der von dem Fehlermittelwertbilder 7 gelieferte augenblickliche Fehlermittelwert und andererseits der von dem Minimalwerterfasser 10 gespeicherte minimale Fehlermittelwert zugeführt werden. Der minimale Fehlermittelwert wird dem Vergleicher 11 vorzugsweise über einen Multiplizierer 9 zugeführt, der diesen Wert mit einem Faktor k etwas größer als 1 bewertet.

Während des zweiten Abschnitts der Trainingsphase dient dieser minimale Fehlermittelwert als Referenzwert für den von dem Vergleicher 11 durchgeführten Vergleich mit dem augenblicklichen Fehlermittelwert. Wegen des periodischen Durchlaufens der optimalen Abtastphase und des somit periodischen Auftretens des Minimalwerts kann nach Beginn des zweiten Abschnitts der Trainingsphase ein erneutes Erreichen oder Auftreten des minimalen Fehlermittelwerts als optimale Abtastphase bzw. optimaler Abtastzeitpunkt interpretiert werden. Der zweite Abschnitt der Trainingsphase wird somit beendet, sobald der von dem Fehlermittelwertbilder 7 gelieferte Fehlermittelwert keiner als der mit dem Faktor k bewertete und gespeicherte minimale Fehlermittelwert ist. In diesem Fall erzeugt der Vergleicher 11 die Steuersignale d und e, welche einerseits den steuerbaren Schalter 6 umschalten, um den Abtasttakt-Regelkreis zu aktivieren, und andererseits die adaptive Einstellung der Filterkoeffizienten für den Entzerrer 2 freigeben.

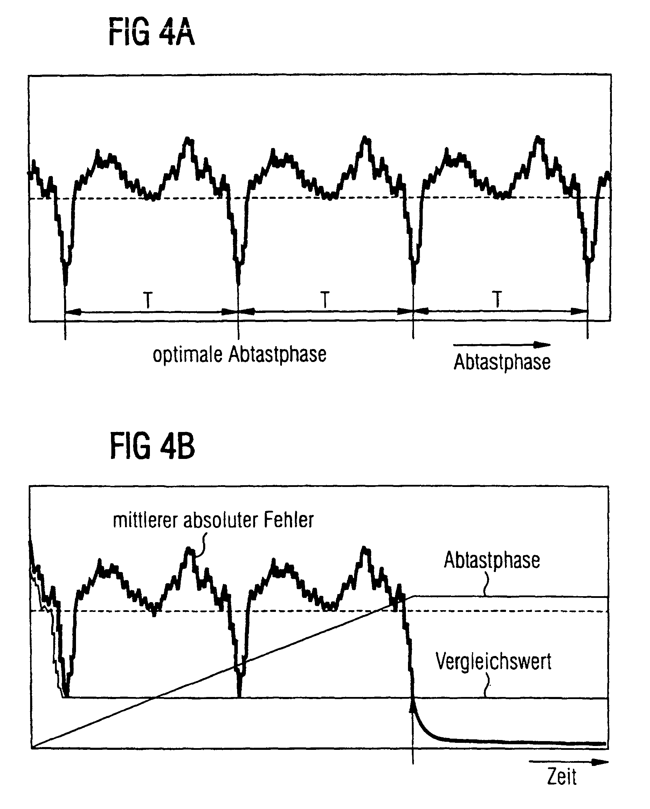

Die Funktionsweise der zuvor beschriebene Schaltung soll nachfolgend näher anhand der in Fig. 4A und 4B gezeigten Darstellungen erläutert werden, wobei Fig. 4A den Verlauf des von dem Fehlermittelwertbilder 7 gelieferten Fehlermittelwerts in Abhängigkeit von der Abtastphase bei einem CAP-System mit einer 4-stufigen nicht 90°-symmetrischen Signalkonstellation (vgl. Fig. 2A und 2B) zeigt, während in Fig. 4B für denselben Fall der zeitabhängige Verlauf des Fehlermittelwerts, der Abtastphase und des von dem Vergleicher 11 gelieferten Vergleichswerts während der zuvor beschriebenen Einlauf- oder Startphase dargestellt ist. Insbesondere ist in Fig. 4B mit einem Pfeil der Zeitpunkt angedeutet, bei dem der Fehlermittelwert erneut seinen Minimalwert erreicht und demzufolge der Abtasttakt-Regelkreis geschlossen wird, um anschließend die Abtastphase bzw. den Abtasttakt konstant auf den somit ermittelten optimalen Startwert zu regeln. Ebenfalls wird zu diesem Zeitpunkt die adaptive Einstellung der Filterkoeffizienten durch den Regelkreis 33 freigegeben. Nach Beendigung der Trainingsphase zu dem mit dem Pfeil dargestellten Zeitpunkt liegt eine für den weiteren Regelvorgang günstige Abtastphase vor, so daß nach dem Umschaltzeitpunkt zur Freigabe bzw. Aktivierung des Abtasttakt-Regelkreises und der adaptiven Einstellung der Filterkoeffizienten eine stabile Synchronisation des Abtasttakts trotz entscheidungsrückgekoppelter Abtasttaktregelung möglich ist.

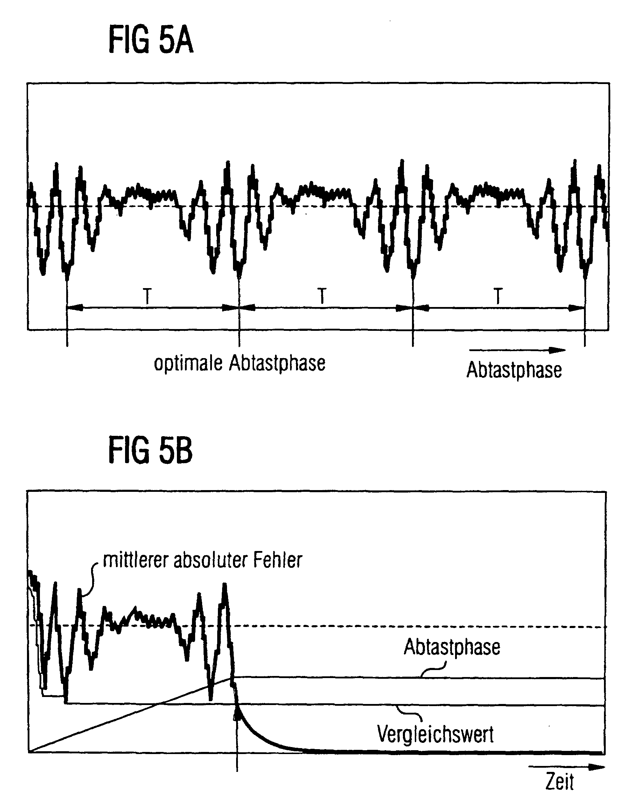

In Fig. 5A und 5B sind die entsprechenden Verläufe für den Fall einer während der Startphase 90°-symmetrischen Signalkonstellation dargestellt (vgl. Fig. 2C und 2D).

Die Umschaltung des Übertragungssignals auf die endgültige Signalkonstellation mit sämtlichen möglichen komplexen Signalpunkten oder Signalvektoren erfolgt vorteilhafterweise nach Beendigung der Startphase erst, wenn der Fehler bzw. Signalrauschabstand am Eingang des Entscheiders 3 einen bestimmten Grenzwert, der von der Stufigkeit der jeweils gewählten Signalkonstellation abhängt, erreicht hat.

**Patentansprüche**

1. Verfahren zur Regelung des Abtasttakts eines phasenmodulierten Signals,
umfassend die Schritte:

   a) Abtasten, Demodulieren und Entzerren eines empfangenen phasenmodulierten Signals ($x_E(t)$), dessen Signalwerte durch Signalvektoren darstellbar sind, um für jeden Signalwert einen entsprechenden Empfangssignalvektor ($a'_Q$, $a'_I$) zu erhalten,
   b) Schätzen eines dem Empfangssignalvektor entsprechenden Sendesignalvektors ($a_Q$, $a_I$),
   c) Vergleichen des im Schritt a) erhaltenen Empfangssignalvektors ($a'_Q$, $a'_I$) und des im Schritt b) geschätzten Sendesignalvektors ($a_Q$, $a_I$), und
   d) Einstellen des Abtasttakts für die im Schritt a) durchgeführte Abtastung in Abhängigkeit von dem im Schritt c) erhaltenen Vergleichsergebnis,

   wobei während einer Startphase der Schritt d) zunächst deaktiviert und das empfangene Signal ($x_E(t)$) im Schritt a) mit einem sich kontinuierlich verändernden Abtasttakt abgetastet und den Schritten b) und c) unterzogen wird,
   **dadurch gekennzeichnet,**
   **daß** ein dem im Schritt c) erhaltenen Vergleichsergebnis entsprechender Fehlerwert ermittelt wird, dessen Minimalwert überwacht wird,
   **daß** ein dem minimalen Fehlerwert entsprechender Start-Abtasttakt ermittelt wird, und
   **daß** nach der Ermittlung des Start-Abtasttakts der Schritt d) aktiviert wird.

2. Verfahren nach Anspruch 1,
   **dadurch gekennzeichnet,**
   **daß** während der Startphase ein Signal ($x_E(t)$) mit einer bestimmten Anzahl von unterschiedlichen Signalvektoren verwendet wird, wobei diese Signalvektoren eine Untermenge der insgesamt möglichen Signalvektoren darstellen.

3. Verfahren nach Anspruch 2,
   **dadurch gekennzeichnet,**
   **daß** während der Startphase ein Signal ($x_E(t)$) mit vier unterschiedlichen Signalvektoren verwendet wird.

4. Verfahren nach einem der Ansprüche 1-3,
   **dadurch gekennzeichnet,**
   **daß** die während der Startphase verwendeten Signalvektoren derart gewählt werden, daß sich im wesentlichen dieselbe Sendeleistung wie beim Senden aller möglicher Si.gnalvektoren ergibt.

5. Verfahren nach einem der Ansprüche 1-4,
   **dadurch gekennzeichnet,**
   **daß** im Schritt a) das abgetastete Signal ($x_E(t)$) in ein digitales Signal umgesetzt und mit Hilfe digitaler Filter (2) entzerrt wird, und
   **daß** die Filterkoeffizienten der digitalen Filter (2) in Abhängigkeit von dem im Schritt c) erhaltenen Vergleichsergebnis adaptiv eingestellt werden,
   wobei die adaptive Einstellung der Filterkoeffizienten während der Startphase deaktiviert und die digitalen Filter (2) mit bestimmten konstanten Filterkoeffizienten betrieben werden, und wobei die adaptive Einstellung der Filterkoeffizienten nach Ermittlung des Start-Abtasttakts freigegeben wird.

6. Verfahren nach Anspruch 5,
   **dadurch gekennzeichnet,**
   **daß** der Signalpegel des den digitalen Filtern (2) zugeführten digitalen Signals automatisch eingestellt wird, und
   **daß** nach der automatischen Einstellung dieses Signalpegels die Startphase für die Ermittlung des Start-Abtasttakts initiiert wird.

7. Verfahren nach einem der vorhergehenden Ansprüche,
   **dadurch gekennzeichnet,**

**daß** die während der Startphase zur Abtastung des empfangenen Signals ($x_E(t)$) verwendete Veränderung des Abtasttakts derart gewählt wird, daß ein minimaler Versatz zwischen der Symbolrate des gesendeten Signals ($x_s(t)$) und der Symbolrate des empfangenen Signals ($x_E(t)$) gegeben ist.

8. Verfahren nach einem der vorhergehenden Ansprüche,
   **dadurch gekennzeichnet,**
   **daß** während der Startphase als Fehlerwert der mittlere absolute Fehler zwischen dem Empfangssignalvektor ($a'_Q$, $a'_I$) und dem geschätzten Sendesignalvektors ($a_Q$, $a_I$) berechnet wird.

9. Verfahren nach einem der vorhergehenden Ansprüche,
   **dadurch gekennzeichnet,**
   **daß** zur Ermittlung des Start-Abtasttakts während der Startphase das Auftreten eines minimalen Fehlerwerts überwacht und im Falle des Auftretens eines minimalen Fehlerwerts dieser minimale Fehlerwert gespeichert und der gespeicherte Fehlerwert mit den nachfolgend ermittelten augenblicklichen Fehlerwerten auf ein erneutes Auftreten des gespeicherten minimalen Fehlerwerts hin. verglichen wird,
   wobei der Zeitpunkt des erneuten Auftretens des gespeicherten minimalen Fehlerwerts als Abtastphase für den Start-Abtasttakt verwendet wird.

10. Verfahren nach einem der vorhergehenden Ansprüche,
    **dadurch gekennzeichnet,**
    **daß** nach der Startphase erst dann ein Signal ($x_E(t)$) mit sämtlichen möglichen Signalvektoren verwendet wird, wenn der Signalrauschabstand des im Schritt a) demodulierten und entzerrte Signal einen bestimmten Grenzwert erreicht hat.

11. Schaltungsanordnung zur Regelung des Abtasttakts eines phasenmodulierten Signals,
    mit einer Abtasteinrichtung (1) zum Abtasten eines empfangenen phasenmodulierten Signals ($x_E(t)$), dessen Signalwerte durch Signalvektoren darstellbar sind, mit einem bestimmten Abtasttakt,
    mit einer Demodulations- und Entzerreinrichtung (2) zum Demodulieren und Entzerren des abgetasteten Signals, um für jeden Abtastwert einen entsprechenden Empfangssignalvektor ($a'_Q$, $a'_I$) auszugeben,
    mit einem Entscheider (3) zum Schätzen eines dem Empfangssignalvektor entsprechenden Sendesignalvektors ($a_Q$, $a_I$), und
    mit einem Abtasttakt-Regelkreis mit einem Taktregler (4) und einem Taktgenerator (13), wobei der Taktregler (4) abhängig von einem Vergleich des von dem Entscheider (3) geschätzten Sendesignalvektors ($a_Q$, $a_I$) mit dem von der Demodulations- und Entzerreinrichtung (2) gelieferten Empfangssignalvektor ($a'_Q$, $a'_I$) ein Einstellsignal für den Taktgenerator (13) zur automatischen Regelung des Abtasttakts erzeugt,
    mit einer Steuereinrichtung (12) , welche während einer Startphase den Abtasttakt-Regelkreis (3, 13) zunächst deaktiviert und an den Taktgenerator (13) eine konstante Verstellinformation anlegt, **dadurch gekennzeichnet,**
    **daß** eine Fehlerminimalwert-Erfassungseinrichtung (7, 10, 11) vorgesehen ist, um in der Startphase abhängig von einem Vergleich des von dem Entscheider (3) geschätzten Sendesignalvektors ($a_Q$, $a_I$) mit dem von der Demodulations- und Entzerreinrichtung (2) gelieferten Empfangssignalvektor ($a'_Q$, $a'_I$) einen minimalen Fehlerwert zu erfassen und davon abhängig einen Start-Abtasttakt zu ermitteln,
    wobei die Steuereinrichtung (12) derart ausgestaltet ist, daß sie nach Ermittlung des Start-Abtasttakts den Abtasttakt-Regelkreis (4, 13) aktiviert.

12. Schaltungsanordnung nach Anspruch 11,
    **dadurch gekennzeichnet,**
    **daß** die Abtasteinrichtung (1) einen Analog/Digital-Wandler zur Umsetzung des empfangenen Signals ($x_E(t)$) in ein digitales Signal umfaßt,
    **daß** die Demodulations- und Entzerreinrichtung (2) digitale Filter zur Entzerrung der einzelnen Werte ($a'_Q$, $a'_I$) des Empfangssignalvektors aufweist, und
    **daß** eine Filterkoeffizienten-Einstelleinrichtung (33) zur adaptiven Einstellung der Filterkoeffizienten der digitalen Filter vorgesehen ist,
    wobei die Steuereinrichtung (12) derart ausgestaltet ist, daß sie die Filterkoeffizienten-Einstelleinrichtung (33) während der Startphase deaktiviert und erst nach Ermittlung des Start-Abtasttakts aktiviert.

13. Schaltungsanordnung nach Anspruch 11 oder 12,
    **dadurch gekennzeichnet,**
    **daß** zwischen der Abtasteinrichtung (1) und der Demodulations- und Entzerreinrichtung (2) ein digitaler Regelverstärker (31, 32) zur Regelung des der Demodulations- und Entzerreinrichtung (2) zugeführten Signalpegels vorgesehen ist, und

**daß** die Steuereinrichtung (12) derart ausgestaltet ist, daß sie die Startphase zur Ermittlung des Start-Abtasttakts nach der Regelung des der Demodulations- und Entzerreinrichtung (2) zugeführten Signalpegels initiiert.

**14.** Schaltungsanordnung nach einem der Ansprüche 11-13,
**dadurch gekennzeichnet,**
**daß** die Fehlerminimalwert-Erfassungseinrichtung (7, 10, 11) eine Fehlermittelwert-Berechnungseinheit (7) zur Berechnung eines Fehlermittelwerts abhängig von dem Vergleich des von dem Entscheider (3) in der Startphase geschätzten Sendesignalvektors ($a_Q$, $a_I$) mit dem von der Demodulations- und Entzerreinrichtung (2) in der Startphase gelieferten Empfangssignalvektor ($a'_Q$, $a'_I$), eine Minimalwert-Erfassungseinheit (10) zur Erfassung eines minimalen Fehlermittelwerts des von der Fehlermittelwert-Berechnungseinheit (7) berechneten Fehlermittelwerts und eine Start-Abtasttakt-Ermittlungseinheit (11) zur Bestimmung des Start-Abtasttakts in Abhängigkeit von dem minimalen Fehlerwert der Minimalwert-Erfassungseinheit (10) umfaßt.

**15.** Schaltungsanordnung nach Anspruch 14,
**dadurch gekennzeichnet,**
**daß** die Fehlermittelwert-Berechnungseinheit (7) derart ausgestaltet ist, daß sie den mittleren absoluten Fehler rekursiv abhängig von dem Vergleich des von dem Entscheider (3) in der Startphase geschätzten Sendesignalvektors ($a_Q$, $a_I$) mit dem von der Demodulations- und Entzerreinrichtung (2) in der Startphase gelieferten Empfangssignalvektor ($a'_Q$, $a'_I$) berechnet.

**16.** Schaltungsanordnung nach Anspruch 14 oder 15,
**dadurch gekennzeichnet,**
**daß** die Start-Abtasttakt-Ermittlungseinheit (11) derart ausgestaltet ist, daß sie nach Erfassen eines minimalen Fehlermittelwerts durch die Minimalwert-Erfassungseinheit (10) den von der Fehlermittelwert-Berechnungseinheit (7) gelieferten augenblicklichen Fehlermittelwert auf das erneute Auftreten des minimalen Fehlerwerts hin überwacht und bei erneutem Auftreten des minimalen Fehlermittelwerts ein Stellsignal (d) zur Aktivierung des Abtasttakt-Regelkreises (4, 13) ausgibt.

**17.** Schaltungsanordnung nach Anspruch 12 und 16,
**dadurch gekennzeichnet,**
**daß** die Start-Abtasttakt-Ermittlungseinheit (11) bei erneutem Auftreten des minimalen Fehlermittelwerts ein Stellsignal (e) zur Aktivierung der Filterkoeffizienten-Einstelleinrichtung (33) ausgibt.

**18.** Schaltungsanordnung nach einem der Ansprüche 11-17,
**dadurch gekennzeichnet,**
**daß** der Taktregler (4) derart ausgestaltet ist, daß er das Einstellsignal für den Taktgenerator (13) anhand eines entscheidungsrückgekoppelten Abtasttakt-Regelkriteriums erzeugt.

**19.** Telekommunikationsempfänger mit einer Schaltungsanordnung nach einem der Ansprüche 11-18,
**dadurch gekennzeichnet,**
**daß** das empfangene Signal ($x_E(t)$) ein QAM- oder ein CAP-Signal ist.

**Claims**

**1.** A method for controlling the sampling clock of a phase-modulated signal,
comprising the steps of:

a) sampling, demodulated and equalizing a received phase-modulated signal ($x_E(t)$), whose signal values can be represented by signal vectors, in order to obtain a corresponding reception signal vector ($a'_Q$, $a'_I$) for each signal value,
b) estimating a transmission signal vector ($a_Q$, $a_I$) corresponding to the reception signal vector,
c) comparing the reception signal vector ($a'_Q$, $a'_I$) obtained in step a) and the transmission signal vector ($a_Q$, $a_I$) estimated in step b), and
d) adjusting the sampling clock for the sampling carried out in step a) as a function of the comparison result obtained in step c),

in which case, during a start phase, step d) is initially deactivated and the received signal ($x_E$(t)) is sampled with a continuously varying sampling clock in step a) and subjected to steps b) and c),

**characterized**

**in that** an error value corresponding to the comparison result obtained in step c) is determined, whose minimum value is monitored,

**in that** a start sampling clock corresponding to the minimum error value is determined, and

**in that** step d) is activated after the determination of the start sampling clock.

2. The method as claimed in claim 1,

    **characterized**

    **in that**, during the start phase, a signal ($x_E$(t)) with a specific number of different signal vectors is used, these signal vectors representing a subset of all the possible signal vectors.

3. The method as claimed in claim 2,

    **characterized**

    **in that**, during the start phase, a signal ($x_E$(t)) with four different signal vectors is used.

4. The method as claimed in one of claims 1-3,

    **characterized**

    **in that** the signal vectors used during the start phase are chosen in such a way as to produce essentially the same transmission power as during the transmission of all the possible signal vectors.

5. The method as claimed in one of claims 1-4,

    **characterized**

    **in that**, in step a), the sampled signal ($x_E$(t)) is converted into a digital signal and equalized with the aid of digital filters (2), and

    **in that** the filter coefficients of the digital filters (2) are adaptively adjusted as a function of the comparison result obtained in step c), the adaptive adjustment of the filter coefficients being deactivated during the start phase and the digital filters (2) being operated with specific constant filter coefficients, and the adaptive adjustment of the filter coefficients being enabled after the determination of the start sampling clock.

6. The method as claimed in claim 5,

    **characterized**

    **in that** the signal level of the digital signal fed to the digital filters (2) is adjusted automatically, and

    **in that**, after the automatic adjustment of this signal level, the start phase or the determination of the start sampling clock is initiated.

7. The method as claimed in one of the preceding claims,

    **characterized**

    **in that** the sampling clock change used during the start phase for sampling the received signal ($x_E$(t)) is chosen in such a way as to give a minimum offset between the symbol rate of the transmitted signal ($x_S$(t)) and the symbol rate of the received signal ($x_E$(t)).

8. The method as claimed in one of the preceding claims,

    **characterized**

    **in that**, during the start phase, the average absolute error between the reception signal vector ($a'_Q$, $a'_I$) and the estimated transmission signal vector ($a_Q$, $a_I$) is calculated as error value.

9. The method as claimed in one of the preceding claims,

    **characterized**

    **in that**, in order to determine the start sampling clock, during the start phase, the occurrence of a minimum error value is monitored and, if a minimum error value occurs, said minimum error value is stored and the stored error value is compared with the subsequently determined instantaneous error values with regard to a renewed occurrence of the stored minimum error value, the instant of the renewed occurrence of the stored minimum error value being used as sampling phase for the start sampling clock.

10. The method as claimed in one of the preceding claims,

    **characterized**

**in that**, after the start phase, a signal ($x_E(t)$) with all possible signal vectors is used only when the signal-to-noise ratio of the signal demodulated and equalized in step a) has reached a specific limit value.

11. A circuit arrangement for controlling the sampling clock of a phase-modulated signal,

having a sampling device (1) for sampling a received phase-modulated signal ($x_E(t)$) whose signal values can be represented by signal vectors, having a specific sampling clock,

having a demodulation and equalization device (2) for demodulating and equalizing the sampled signal, in order to output a corresponding reception signal vector ($a'_Q$, $a'_I$) for each sample,

having a decision unit (3) for estimating a transmission signal vector ($a_Q$, $a_I$) corresponding to the reception signal vector, and

having a sampling clock control circuit having a clock controller (4) and a clock generator (13), the clock controller (4), depending on a comparison between the transmission signal vector ($a_Q$, $a_I$) estimated by the decision unit (3) and the reception signal vector ($a'_Q$, $a'_I$) supplied by the demodulation and equalization device (2), generating an adjustment signal for the clock generator (13) for automatic control of the sampling clock,

having a control device (12) which, during a start phase, initially deactivates the sampling clock control signal (3, 13) and applies a constant adjustment information item to the clock generator (13), **characterized in that** an error minimum value detection device (7, 10, 11) is provided in order to detect, in the start phase, depending on a comparison between the transmission signal vector ($a_Q$, $a_I$) estimated by the decision signal (3) and the reception signal vector ($a'_Q$, $a'_I$) supplied by the demodulation and equalization device, a minimum error value and to determine, depending on the latter, a start sampling clock,

the control device (12) being configured in such a way that it activates the sampling clock control circuit (4, 13) after the determination of the start sampling clock.

12. The method as claimed in claim 11,

**characterized**

**in that** the sampling device (1) comprises an analog/digital converter for converting the received signal ($x_E(t)$) into a digital signal,

**in that** the demodulation and equalization device (2) has digital filters for equalizing the individual values ($a'_Q$, $a'_I$) of the reception signal vector, and

**in that** a filter coefficient adjustment device (33) is provided for adaptive adjustment of the filter coefficients of the digital filters,

the control device (12) being configured in such a way that it deactivates the filter coefficient adjusting device (33) during the start phase and activates it only after the determination of the start sampling clock.

13. The circuit arrangement as claimed in claim 11 or 12,

**characterized**

**in that** a digital control amplifier (31, 32) for controlling the signal level fed to the demodulation and equalization device (2) is provided between the sampling device (1) and the demodulation and equalization device (2), and

**in that** the control device (12) is configured in such a way that it initiates the start phase for determining the start sampling clock after the control of the signal level fed to the demodulation and equalization device.

14. The circuit arrangement as claimed in one of claims 11-13,

**characterized**

**in that** the error minimum value detection device (7, 10, 11) comprises an error average value calculation unit (7) for calculating an error average value depending on the comparison between the transmission signal vector ($a_Q$, $a_I$) estimated by the decision unit (3) in the start phase and the reception signal vector ($a'_Q$, $a'_I$) supplied by the demodulation and equalization device (2) in the start phase, a minimum value detection unit (10) for detecting a minimum error average value of the error average value calculated by the error average value calculation unit (7), and a start sampling clock determination unit (11) for determining the start sampling clock as a function of the minimum error value of the minimum value detection unit (10).

15. The circuit arrangement as claimed in claim 14,

**characterized**

**in that** the error average value calculation unit (7) is configured in such a way that it calculates the average absolute error recursively depending on the comparison between the transmission signal vector ($a_Q$, $a_I$) estimated by the decision unit (3) in the start phase and the reception signal vector ($a'_Q$, $a'_I$) supplied by the demodulation and equalization device (2) in the start phase.

**16.** The circuit arrangement as claimed in claim 14 or 15,
**characterized**
**in that** the start sampling clock determination unit (11) is configured in such a way that, after the detection of a minimum error average value by the minimum value detection unit (10), it monitors the instantaneous error average value supplied by the error average value calculation unit (7), with regard to the renewed occurrence of the minimum error value and, in the event of renewed occurrence of the minimum error average value, outputs an actuating signal (d) for activating the sampling clock control circuit (4, 13).

**17.** The circuit arrangement as claimed in claims 12 and 16,
**characterized**
**in that** the start sampling clock determination unit (11), in the event of renewed occurrence of the minimum error average value, outputs an actuating signal (e) for activating the filter coefficients adjusting device (33).

**18.** The circuit arrangement as claimed in one of claims 11-17,
**characterized**
**in that** the clock controller (4) is configured in such a way that it generates the adjusting signal for the clock generator (13) on the basis of a decision feedback sampling clock control criterion.

**19.** A telecommunications receiver having a circuit arrangement as claimed in one of claims 11-18,
**characterized**
**in that** the received signal ($x_E(t)$) is a QAM signal or a CAP signal.

**Revendications**

**1.** Procédé pour réguler le taux d'échantillonnage d'un signal modulé en phase,
comprenant les étapes consistant à :

a) échantillonner, démoduler et égaliser un signal reçu modulé en phase ($x_E(t)$), dont les valeurs de signal peuvent être représentées par des vecteurs de signaux, pour obtenir pour chaque valeur de signal un vecteur de signal reçu correspondant ($a'_Q$, $a'_I$),
b) évaluer un vecteur de signal émis ($a_Q$, $a_I$) correspondant au vecteur de signal reçu,
c) comparer le vecteur de signal reçu ($a'_Q$, $a'_I$) obtenu dans l'étape a) au vecteur de signal émis ($a_Q$, $a_I$) évalué dans l'étape b), et
d) régler le taux d'échantillonnage pour l'échantillonnage réalisé dans l'étape a) en fonction du résultat de la comparaison obtenu dans l'étape c),

dans lequel pendant une étape de démarrage, l'étape d) est d'abord désactivée et le signal reçu ($x_E(t)$) est échantillonné dans l'étape a) avec un taux d'échantillonnage changeant continuellement et soumis aux étapes b) et c),
**caractérisé en ce** le taux d'échantillonnage
qu'une valeur d'erreur correspondant au résultat de la comparaison obtenu dans l'étape c) est calculée et sa valeur minimale est surveillée,
en ce qu'un taux d'échantillonnage au démarrage correspondant à la valeur d'erreur minimale est calculée, et en ce que
l'étape d) est activée après la détermination du taux d'échantillonnage au démarrage.

**2.** Procédé selon la revendication 1,
**caractérisé en ce que**
pendant l'étape de démarrage, un signal ($x_E(t)$) avec un certain nombre de vecteurs de signaux différents est utilisé, ces vecteurs de signaux représentant un sous-ensemble de la totalité des vecteurs de signaux possibles.

**3.** Procédé selon la revendication 2,
**caractérisé en ce que**
pendant l'étape de démarrage, un signal ($x_E(t)$) avec quatre vecteurs de signaux différents est utilisé.

**4.** Procédé selon l'une quelconque des revendications 1 à 3,
**caractérisé en ce que**
les vecteurs de signaux utilisés pendant l'étape de démarrage sont choisis de manière à ce qu'il en résulte essentiellement la même puissance d'émission que celle obtenue lors de l'émission de la totalité des vecteurs de signaux possibles.

5. Procédé selon l'une quelconque des revendications 1 à 4,
   **caractérisé en ce que**
   dans l'étape a), le signal échantillonné ($x_E$(t)) est converti en un signal numérique et qu'il est égalisé à l'aide d'un filtre numérique (2), et **en ce que**
   les coefficients de filtrage des filtres numériques (2) sont réglés de manière adaptive en fonction du résultat de la comparaison obtenu dans l'étape c),
   le réglage adaptif des coefficients de filtrage étant désactivé pendant l'étape de démarrage et les filtres numériques (2) fonctionnant avec des coefficients de filtrage constants déterminés, et le réglage adaptif des coefficients de filtrage étant autorisé après la détermination du taux d'échantillonnage au démarrage.

6. Procédé selon la revendication 5,
   **caractérisé en ce que**
   le niveau de signal du signal numérique envoyé dans les filtres numériques (2) est réglé automatiquement, et
   **en ce qu'**après le réglage automatique de ce niveau de signal, l'étape de démarrage est amorcée pour la détermination du taux d'échantillonnage au démarrage.

7. Procédé selon l'une quelconque des revendications précédentes,
   **caractérisé en ce que**
   pendant l'étape de démarrage, le changement du taux d'échantillonnage utilisé pour l'échantillonnage du signal reçu ($x_E$(t)) est choisi de manière à ce qu'il existe un décalage minimal entre le débit d'information du signal émis ($x_S$(t)) et le débit d'information du signal reçu ($x_E$(t)).

8. Procédé selon l'une quelconque des revendications précédentes,
   **caractérisé en ce que**
   pendant l'étape de démarrage, on calcule en tant que valeur d'erreur, l'erreur moyenne absolue entre le vecteur de signal reçu ($a'_Q$, $a'_I$) et le vecteur de signal émis évalué ($a_Q$, $a_I$).

9. Procédé selon l'une quelconque des revendications précédentes,
   **caractérisé en ce que**
   , pour la détermination du taux d'échantillonnage au démarrage pendant l'étape de démarrage, la survenue d'une valeur d'erreur minimale est surveillée et, dans le cas de la survenue d'une valeur d'erreur minimale, cette valeur d'erreur minimale est mémorisée et la valeur d'erreur mémorisée est comparée aux valeurs d'erreur instantanées déterminées ultérieurement en prévision d'une nouvelle survenue de la valeur d'erreur minimale mémorisée, le moment de la nouvelle survenue de la valeur d'erreur minimale mémorisée étant utilisé en tant qu'étape d'échantillonnage pour le taux d'échantillonnage au démarrage.

10. Procédé selon l'une quelconque des revendications précédentes,
    **caractérisé en ce que**
    seulement après l'étape de démarrage, un signal ($x_E$(t)) avec tous les vecteurs de signaux possibles est utilisé, une fois que le rapport signal/bruit du signal démodulé et égalisé dans l'étape a) a atteint une certaine valeur limite.

11. Assemblage d'éléments pour réguler le taux d'échantillonnage d'un signal modulé en phase,
    comprenant un dispositif d'échantillonnage (1) pour échantillonner un signal reçu modulé en phase ($x_E$(t)), dont les valeurs de signal peuvent être représentées par des vecteurs de signaux, qui possède un certain taux d'échantillonnage,
    comprenant un dispositif de démodulation et d'égalisation (2) pour démoduler et égaliser le signal échantillonné afin d'obtenir pour chaque valeur d'échantillon un vecteur de signal reçu ($a'_Q$, $a'_I$) correspondant,
    comprenant un organe de décision (3) pour évaluer un vecteur de signal émis ($a_Q$, $a_I$) correspondant au vecteur de signal reçu, et
    comprenant une boucle d'asservissement du taux d'échantillonnage avec un régulateur de taux (4) et un générateur de taux (13), le régulateur de taux (4) produisant un signal de réglage pour le générateur de taux (13), en vue de réguler automatiquement le taux d'échantillonnage, en fonction d'une comparaison du vecteur de signal émis ($a_Q$, $a_I$) évalué par l'organe de décision (3) au vecteur de signal reçu ($a'_Q$, $a'_I$) fourni par le dispositif de démodulation et d'égalisation (2),
    comprenant un dispositif de commande (12), qui désactive d'abord la boucle d'asservissement du taux d'échantillonnage (3, 13) pendant une étape de démarrage et qui fournit des informations de réglage constantes au générateur de taux (13),

**caractérisé en ce**

**qu'**un dispositif de détection d'une valeur d'erreur minimale (7, 10, 11) est prévu pour détecter une valeur d'erreur minimale pendant l'étape de démarrage en fonction d'une comparaison du vecteur de signal émis ($a_Q$, $a_I$) évalué par l'organe de décision (3) au vecteur de signal reçu ($a'_Q$, $a'_I$) fourni par le dispositif de démodulation et d'égalisation (2) et pour calculer en fonction de ceci un taux d'échantillonnage au démarrage,

le dispositif de commande (12) étant conçu de sorte qu'il active la boucle d'asservissement du taux d'échantillonnage (4, 13) après la détermination du taux d'échantillonnage au démarrage.

**12.** Assemblage d'éléments selon la revendication 11,

**caractérisé**

**en ce que** le dispositif d'échantillonnage (1) comprend un convertisseur analogique/numérique pour convertir le signal reçu ($x_E(t)$) en un signal numérique,

**en ce que** le dispositif de démodulation et d'égalisation (2) présente des filtres numériques pour égaliser les valeurs individuelles ($a'_Q$, $a'_I$) du vecteur de signal reçu, et

**en ce qu'**un dispositif de réglage des coefficients de filtrage (33) est prévu pour régler automatiquement les coefficients de filtrage du filtre numérique,

le dispositif de commande (12) étant conçu de sorte qu'il désactive le dispositif de réglage des coefficients de filtrage (33) pendant l'étape de démarrage et qu'il ne l'active qu'après la détermination du taux d'échantillonnage au démarrage.

**13.** Assemblage d'éléments selon la revendication 11 ou 12,

**caractérisé**

**en ce qu'**un amplificateur numérique de régulation (31, 32) est prévu entre le dispositif d'échantillonnage (1) et le dispositif de démodulation et d'égalisation (2) pour réguler le niveau du signal envoyé dans le dispositif de démodulation et d'égalisation (2), et

**en ce que** le dispositif de commande (12) est conçu de sorte qu'il amorce l'étape de démarrage pour la détermination du taux d'échantillonnage au démarrage après la régulation du niveau de signal envoyé dans le dispositif de démodulation et d'égalisation (2).

**14.** Procédé selon l'une quelconque des revendications 11 à 13,

**caractérisé**

**en ce que** le dispositif de détection d'une valeur d'erreur minimale (7, 10, 11) comprend une unité de calcul de la valeur moyenne d'erreur (7) pour calculer une valeur moyenne d'erreur en fonction de la comparaison du vecteur de signal émis ($a_Q$, $a_I$) évalué par l'organe de décision (3) pendant l'étape de démarrage au vecteur de signal reçu ($a'_Q$, $a'_I$) fourni par le dispositif de démodulation et d'égalisation (2) pendant l'étape de démarrage, une unité de détection de valeur minimale (10) pour détecter une valeur moyenne d'erreur minimale de la valeur moyenne d'erreur calculée par l'unité de calcul de la valeur moyenne d'erreur (7) et une unité de calcul du taux d'échantillonnage au démarrage (11) pour déterminer le taux d'échantillonnage au démarrage en fonction de la valeur d'erreur minimale de l'unité de détection de valeur minimale (10).

**15.** Assemblage d'éléments selon la revendication 14,

**caractérisé en ce que**

l'unité de calcul de la valeur moyenne d'erreur (7) est conçue de sorte qu'elle calcule l'erreur moyenne absolue de manière récursive en fonction de la comparaison du vecteur de signal émis ($a_Q$, $a_I$) évalué par l'organe de décision (3) pendant l'étape de démarrage au vecteur de signal reçu ($a'_Q$, $a'_I$) fourni par le dispositif de démodulation et d'égalisation (2) pendant l'étape de démarrage.

**16.** Assemblage d'éléments selon la revendication 14 ou 15,

**caractérisé en ce que**

l'unité de calcul du taux d'échantillonnage au démarrage (11) est conçue de sorte qu'après la détection d'une valeur moyenne d'erreur minimale par l'unité de détection de valeur minimale (10), elle surveille la valeur moyenne d'erreur instantanée fournie par l'unité de calcul de la valeur moyenne d'erreur (7) en vue d'une nouvelle survenue de la valeur moyenne d'erreur minimale et que lors de la nouvelle survenue d'une valeur moyenne d'erreur minimale, elle émet un signal de réglage (d) pour activer la boucle d'asservissement du taux d'échantillonnage (4, 13).

**17.** Assemblage d'éléments selon la revendication 16 ou 12,

**caractérisé en ce que**

lors d'une nouvelle survenue de la valeur moyenne d'erreur minimale, l'unité de calcul du taux d'échantillonnage au démarrage (11) émet un signal de réglage (e) pour activer l'unité de réglage des coefficients de filtrage (33).

18. Procédé selon l'une quelconque des revendications 11 à 17,
    **caractérisé en ce que**
    le régulateur de taux (4) est conçu de sorte qu'il produit un signal de régulation pour le générateur de taux (13) en s'appuyant sur un critère de régulation du taux d'échantillonnage asservi à l'organe de décision.

19. Récepteurs de télécommunications comprenant un assemblage d'éléments selon l'une quelconque des revendications 11 à 18,
    **caractérisés en ce que**
    le signal reçu ($x_E(t)$) est un signal MAQ ou CAP.

FIG 1

$x_E(t)$

A/D — 1

Digitaler Regelverstärker (AGC) — 32

⊗ — 31

Demodulator und Entzerrer — 2

a'Q
a'I

Fehlermittel-wertbilder — 7

Entscheider — 3

$a_Q, a_I$

Taktregler — 4

Takt-generator — 13

Einstellung der Filter-Koeffizienten — 33
↓e

↓f

Konstante Verstellgröße

d — 6

Filter — 5

8
a

Minimalwert-erfasser — 10
b

⊗ k — 9

Vergleicher — 11
c

Ablauf-steuerung — 12

↓f

↓d, e

EP 1 175 760 B1

16

FIG 2A

FIG 2B

FIG 2C

FIG 2D

FIG 3

## FIG 4A

optimale Abtastphase

Abtastphase

## FIG 4B

mittlerer absoluter Fehler

Abtastphase

Vergleichswert

Zeit

## FIG 5A

optimale Abtastphase

Abtastphase

## FIG 5B

mittlerer absoluter Fehler

Abtastphase

Vergleichswert

Zeit

# FIG 6

$a_I$ → | D/A | (24a) → | Filter | (25a) → ⊗ (26a) ← $\cos(2\pi f_0 t)$

→ ⊕ (27) → $x_S(t)$

$a_Q$ → | D/A | (24b) → | Filter | (25b) → ⊗ (26b) ← $\sin(2\pi f_0 t)$

# FIG 7

$\cos(2\pi f_0 t)$ → ⊗ (28a) → | Filter | (29a) → | A/D | (30a) → $a_I$

$x_E(t)$ →

$\sin(2\pi f_0 t)$ → ⊗ (28b) → | Filter | (29b) → | A/D | (30b) → $a_Q$